# EUROPEAN PATENT APPLICATION

(11) **EP 1 437 609 A1**
(43) Date of publication of application: **14.07.2004**
(21) Application number: 02785927.1
(22) Date of filing: 18.10.2002
(51) Int. Cl.: G02B 5/28, C23C 14/06, C23C 14/34, G02B 1/11

(54) **OPTICAL ELEMENT AND PRODUCTION METHOD THEREFOR, AND BAND PASS FILTER, NEAR INFRARED CUT FILTER AND ANTI-REFLECTION FILM**

(30) Priority: 18.10.2001 JP 2001320971; 18.10.2001 JP 2001320972; 18.10.2001 JP 2001320973
(71) Applicant: BRIDGESTONE CORPORATION, Tokyo 104-0031 (JP)
(72) Inventor: YOSHIKAWA, Masato, Kodaira-shi, Tokyo 187-8531 (JP); OONO, Shingo, Kodaira-shi, Tokyo 187-8531 (JP); KOBAYASHI, Taichi, Kodaira-shi, Tokyo 187-8531 (JP); IWABUCHI, Yoshinori, Kodaira-shi, Tokyo 187-8531 (JP)
(74) Representative: Staudt, Hans-Peter, Dipl.-Ing.
(86) International application number: PCT/JP2002/010826
(87) International publication number: WO 2003/034106

(57) **Abstract**

An optical element such as a band-pass filter, near-infrared cut filter or antireflection film which can be prepared in high rate and hence in high productivity and whose preparation can be carried out by the application of high electric power to a target. In the optical element, a low refractive index layer is formed using conductive silicon carbide as a target by a sputtering method and a high refractive index layer is formed using conductive titanium oxide as a target by a sputtering method.

## Description

### Background of Invention

### 1. Field of the invention

The present invention relates to an optical element having high refractive index layers and low refractive index layers superposed alternately, which can be advantageously used in a band-pass filter suitably utilized for an optical fiber, a near-infrared cut filter suitably utilized for a front filter of plasma display and an antireflection film suitably mounted on various displays, and the process for the preparation thereof.

### 2. Description of the Related Art

Optical elements, which can be advantageously used in band-pass filters utilized in optical communication field for controlling the wavelength of light passing through optical fibers, near-infrared cut filters utilized for a front filter of plasma display panel (PDP) and antireflection films for controlling light reflected on the surface of various displays to enhance visibility, are prepared by superposing alternately high refractive index layer(s) and low refractive index layer(s).

For example, the band-pass filters having the alternately superposed high and low refractive index layers as mentioned above are used for transmit only light of an optional wavelength region. As the band-pass filters, there are known those that transparent layers such as MgF₂, SiO₂ and TiO₂ are superposed.

The near-infrared cut filters are, for example, provided on the front of the plasma display panel (PDP), or utilized as energy-saving films. In more detail, the plasma display panel (PDP) has the properties of emitting near-infrared radiation in the wavelength region of 850 to 1,200nm, and hence the emitted near-infrared radiation causes malfunction of a remote-controller used in home electric appliances because the remote-controller uses near-infrared radiation in the wavelength region of 700 to 1,300nm. Therefore near-infrared cut filters for cutting the near-infrared radiation causing the malfunction are mounted on the front of the PDP.

Further, since the near-infrared cut filters naturally cut near-infrared radiation of the sun, the near-infrared cut filters are used as energy-saving-films for enhancing the efficiency of air-cooling by mounting the filters on windows of vehicles or buildings in the summer period. As the near-infrared cut filters, there are known those that high refractive index layers such as silver and indium oxide and low refractive index layers such as silver or materials containing silver are alternately superposed, which are, for example, described in JP-A-12-167969.

The antireflection films have been provided on the surfaces of various displays such as CRT, LCD and PDP to control light reflected on the surfaces of the displays and to enhance visibility, before now. The antireflection films also have the function of transmitting only light of the optional wavelength region by the adoption of the structure of the alternately superposed high and low refractive index layers. As the antireflection films, there are known those that high refractive index layers such as TiO₂ and low refractive index layers such as SiO₂ and ZnO are alternately superposed on an organic film, which are, for example, described in JP-A-11-142603 and JP-A-12-206306.

As mentioned above, all the optical elements such as the band-pass filters, the near-infrared cut filters and the antireflection films preferably provided on various displays have a structure of the alternately superposed high and low refractive index layers on a transparent plate such as a glass plate. The structure of the alternately superposed high and low refractive index layers is formed by sputtering method, which is widely utilized for the formation of uniform thin film (thickness of nano-order) having large area.

### Summary of the Invention

The rate (speed) for forming the thin film by the sputtering method mentioned above is extremely small and hence the sputtering method has low productivity. To solve the problem, a process that can be sputtered in high rate by disposing two cathodes in parallel and applying AC (alternating current) to them (i.e., dual-cathode sputtering method) is proposed in JP-A-12-167969. However, the rate for forming the thin film is not still sufficiently increased to industrially prepare the thin film. Further, Si target used in the formation of the low refractive index thin layer is brittle and hence there is problem that the Si target is apt to crack in the application of high electric power.

In view of the above-mentioned problems, the object of the present invention is to provide an optical element (e.g., optical filter) which can be prepared in high rate and hence in high productivity and whose preparation can be carried out by the application of high electric power.

Further, the object of the present invention is to provide a band-pass filter which can be prepared in high rate and hence in high productivity and whose preparation can be carried out by the application of high electric power to a target.

Furthermore, the object of the present invention is to provide a near-infrared cut filter which can be prepared in high rate and hence in high productivity and whose preparation can be carried out by the application of high electric power to a target.

Moreover, the object of the present invention is to provide an antireflection film which can be prepared in high rate and hence in high productivity and whose preparation can be carried out by the application of high electric power to a target.

Still, the object of the present invention is to provide a process for advantageously preparing the above optical element.

The invention is provided by an optical element comprising a substrate, and at least one low refractive index layer and at least one high refractive index layer superposed alternately thereon, wherein the low refractive index layer is formed using conductive silicon carbide as a target by a sputtering method and the high refractive index layer is formed using conductive titanium oxide as a target by a sputtering method.

In the optical element, the low refractive index layer preferably comprises a compound containing Si and at least one atom selected from the group consisting of C, O and N, and the high refractive index layer preferably comprises a compound containing Ti and O. Further, the low refractive index layer preferably comprises a silicon compound selected from a group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, y is in the range of 0.1 to 3 and z is in the range of 0.1 to 3, and the high refractive index layer preferably comprises TiOₜ in which t is in the range of 0.1 to 3.

Further, the invention is provided by process for the preparation of an optical element comprising superposing alternately at least one high refractive index layer and at least one low refractive index layer superposed on a substrate which comprises the steps of:
forming the high refractive index layer using conductive titanium oxide as a target by a sputtering method, and
forming the low refractive index layer using conductive silicon carbide as a target by a sputtering method.

In the process, the sputtering method is preferably a magnetron sputtering method, especially a dual cathode type magnetron sputtering method. The low refractive index layer is generally formed in atmosphere of a mixture gas consisting of an inert gas and a reactive gas. The reactive gas preferably is a gas containing an oxygen atom in its molecule. The low refractive index layer preferably comprises a silicon compound selected from the group consisting of SiCₓ, SiOₓ, SiNₓ, SiCₓO_{y}, SiCₓN_{y}, Si-OₓN_{y} and SiCₓO_{y}N_{z} in which x is in the range of 0.1 to 3, y is in the range of 0.1 to 3 and z is in the range of 0.1 to 3, and the high refractive index layer comprising TiOₜ in which t is in the range of 0.1 to 3.

The silicon carbide target preferably has density of not less than 2.9g/cm³. The silicon carbide target is preferably prepared by sintering a mixture of silicon carbide powder and nonmetallic sintering auxiliary agent.

In the sputtering method, the operation is preferably carried out so that the carbon compounds such as the silicon carbide are not deposited in a chamber of the sputtering equipment and are not entered into a transparent conductive layer during the operation (film-forming process). In more detail, when the carbon compounds are vaporized in the sputtering, the vaporized gas is preferably removed from the chamber. Thereby the carbon compounds are not deposited in the chamber and not entered into the transparent conductive layer during the operation.

Further, the invention is provided by an optical element comprising a substrate, and at least one low refractive index layer and at least one high refractive index layer superposed alternately thereon, wherein the low refractive index layer comprises a silicon compound selected from the group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, y is in the range of 0.1 to 3 and z is in the range of 0.1 to 3, and the high refractive index layer comprises TiOₜ in which t is in the range of 0.1 to 3.

In the optical element, the low refractive index layer preferably comprises the SiCₓO_{y}.

Moreover, the invention is provided by a band-pass filter comprising the optical element as described above. The band-pass filter preferably has light transmission of not less than 50% in a wavelength region of 560 to 620nm. Particularly, the light transmission preferably is not more than 50% in a wavelength region of less than 560nm (especially in a wavelength region of less than 560nm and not less than 550nm) and in a wavelength region of more than 620nm (especially in a wavelength region of more than 620nm and not more than 640nm), further preferably is not more than 50% in a wavelength region of less than 585nm (especially in a wavelength region of less than 585nm and not less than 550nm) and in a wavelength region of more than 592nm (especially in a wavelength region of more than 592nm and not more than 640nm).

Further, the invention is provided by a near-infrared cut filter comprising the optical element as described above. The filter preferably has light transmission of not more than 50% in a wavelength region of 900 to 1,100nm. Particularly, the light transmission preferably is not more than 50% in a wavelength region of 850 to 1,150nm and not less than 50% in a wavelength region of not more than 700nm (especially in a wavelength region of not more than 700nm and not less than 400nm).

The near-infrared cut filter can be advantageously used in a filter for the front of a plasma display and an energy-saving film.

Furthermore, the invention is provided by an antireflection film comprising the optical element as described above. The antireflection film preferably prevents the reflection of light of a wavelength region of 380 to 780nm.

### Brief Description of the Drawings

Fig. 1 is a section view showing an example of a band-pass filter according to the present invention.
Fig. 2 is a section view showing an example of a near-infrared cut filter according to the present invention.
Fig. 3 is a section view showing an example of an antireflection film according to the present invention.
Fig. 4 is a graph showing the relationship of reflectivity (R) and transmittance (T) of a band-pass filter obtained in Example 1.
Fig. 5 is a graph showing the relationship of reflectivity (R) and transmittance (T) of a near-infrared cut filter obtained in Example 2.
Fig. 6 is a graph showing the relationship of reflectivity (R) and transmittance (T) of a near-infrared cut filter obtained in Example 3.
Fig. 7 is a graph showing reflectivity of an antireflection film obtained in Example 4.

### Detailed Description of the Invention

Embodiments of the optical element (preferably of a band-pass filter, a near-infrared cut filter or an antireflection film) according to the invention are explained in detail.

First, the embodiments of the band-pass filter as the optical element according to the invention are explained. The band-pass filter of the invention means a film capable of transmitting only the light of the specified wavelength region. For example, a wide-band-pass filter capable of transmitting only the light of the specified wavelength region in the half-width of approx. 50 to 500nm, the transmittance being not less than 10%, and a narrow-band-pass filter capable of transmitting only the light of the specified wavelength region in the half-width of approx. 1 to 50nm, the transmittance being not less than 10%.

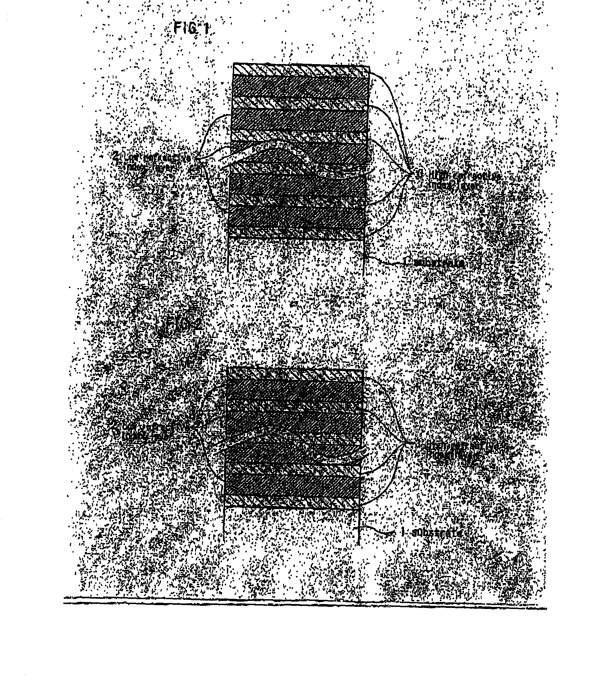

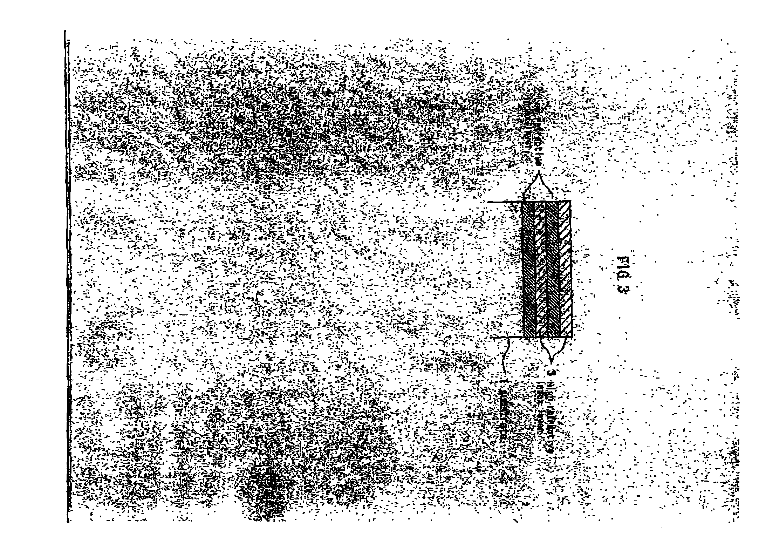

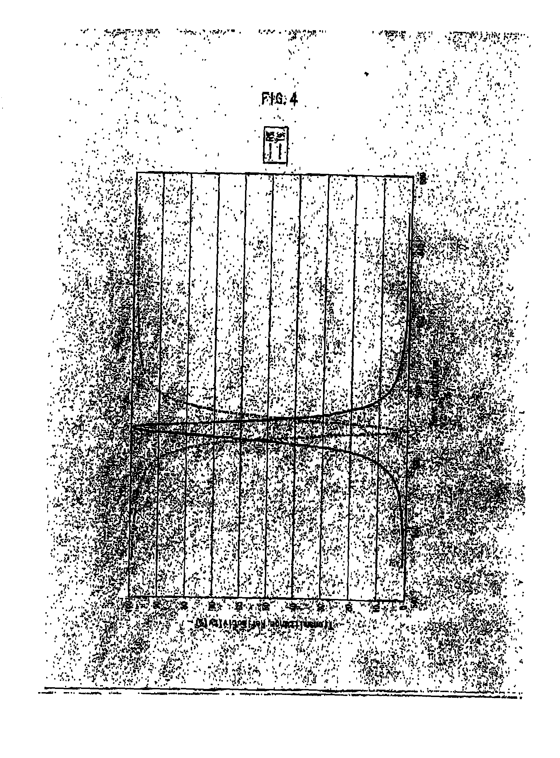

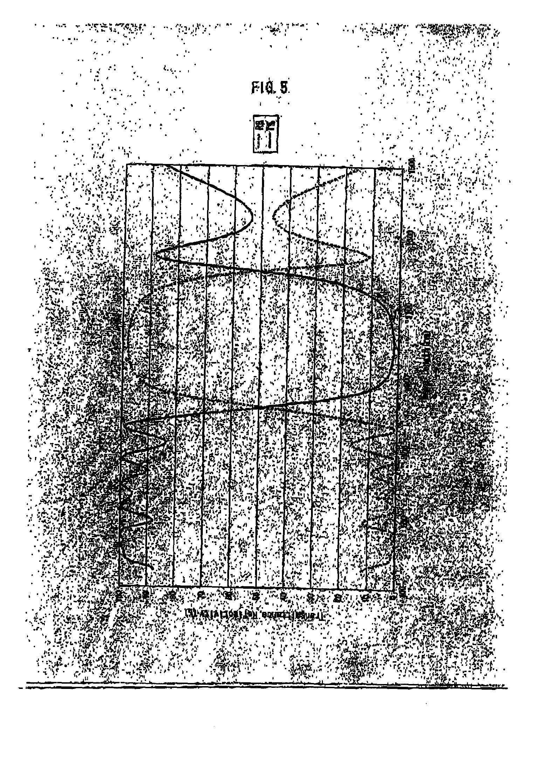

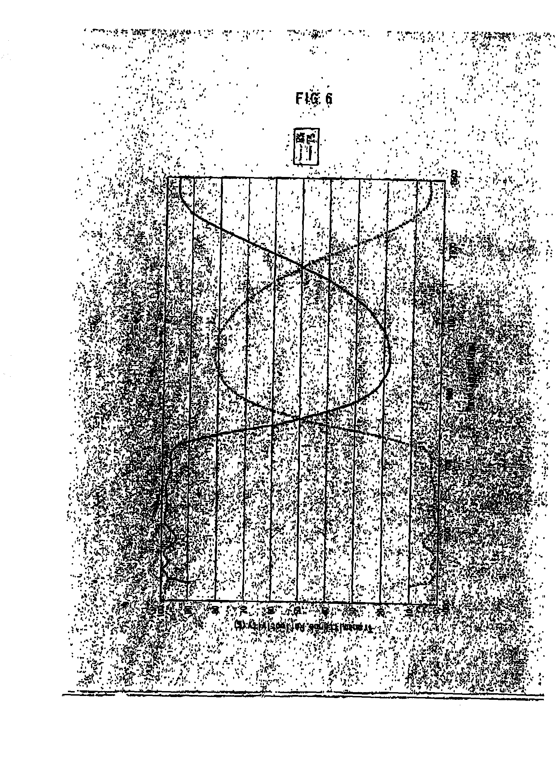

Fig. 1 is a section view showing an example of a structure of the band-pass filter of the invention. The band-pass filter of the invention has a basic structure that high refractive index layers 3 and low refractive index layers 2 are alternately superposed one by one on a substrate 1. In the invention, the low refractive index layers are formed using conductive silicon carbide as a target by a sputtering method. The use of the electrically conductive silicon carbide as a target enables the application of high power without occurrence of crack in the target. Further, the high refractive index layers are formed using electrically conductive titanium oxide as a target by a sputtering method. The use of the conductive titanium oxide as a target enables increase of rate for forming film. These layers may not have the same thickness as one another, and the thicknesses are set depending upon the desired characteristics.

In the laminate having the high and low refractive index layers, the thickness of each of the layers and the laminated number of the layers are optionally designed so as to have the characteristics required of a band-pass filter. For example, by superposing a first layer of TiOₜ having thickness of 58.1nm, a second layer of SiCₓO_{y} having thickness of 101.1nm, a third layer of TiOₜ having thickness of 58.1nm, a forth layer of SiCₓO_{y} having thickness of 101.1nm, a fifth layer of TiOₜ having thickness of 58.1nm, a sixth layer of SiCₓO_{y} having thickness of 101.1nm, a seventh layer of TiOₜ having thickness of 58.1nm, an eighth layer of SiCₓO_{y} having thickness of 176.9nm, a ninth layer of TiOₜ having thickness of 60.0nm, a tenth layer of SiCₓO_{y} having thickness of 176.9nm, an eleventh layer of TiOₜ having thickness of 58.1nm, a twelfth layer of SiCₓO_{y} having thickness of 101.1nm, a thirteenth layer of TiOₜ having thickness of 58.1nm, a fourteenth layer of SiCₓO_{y} having thickness of 101.1nm, a fifteenth layer of TiOₜ having thickness of 58.1nm, a sixteenth layer of SiCₓO_{y} having thickness of 101.1nm and a seventeenth layer of TiOₜ having thickness of 58.1nm, in which x is in the range of 0.1 to 3, y is in the range of 0.1 to 3 and z is in the range of 0.1 to 3, a band-pass filter having the characteristics of transmitting the light of a wavelength of 585 to 592nm in the transmittance of not less than 50% is generally prepared.

Subsequently, the embodiments of the near-infrared cut filter as the optical element according to the invention are explained. The near-infrared radiation in the invention mean radiation of a wavelength region of not less than that of visible radiation, i.e., radiation (light) of a wavelength region of not less than 760nm and not more than 2,500nm. The near-infrared cut filter of the invention is not required to reflect the full near-infrared radiation. In more detail, the near-infrared cut filter of the invention has generally transmittance of not more than 50% of the near-infrared radiation emitted by PDP, i.e., the near-infrared radiation of a wavelength region of approx 850nm to at least approx. 1,200nm.

The transmittance of the near-infrared cut filter of the invention preferably is 50% or less with respect to the near-infrared radiation of a wavelength region of 900 to 1,100nm, especially 850 to 1,150nm, and 50% or more with respect to radiation of a wavelength region of not more than 700nm.

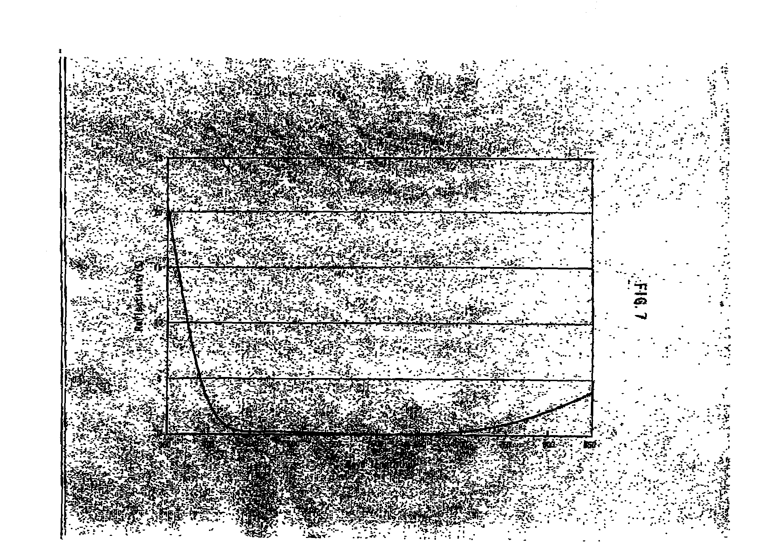

Fig. 2 is a section view showing an example of a structure of the near-infrared cut filter of the invention. The near-infrared cut filter of the invention has a basic structure that low refractive index layers 2 and high refractive index layers 3 are alternately superposed one by one on a substrate 1. In the invention, the low refractive index layers are formed using conductive silicon carbide as a target by a sputtering method. The use of the conductive silicon carbide as a target enables the application of high power without occurrence of crack in the target. Further, the high refractive index layers are formed using conductive titanium oxide as a target by a sputtering method. The use of the conductive titanium oxide as a target enables increase of the rate for forming film.

In the laminate having the low and high refractive index layers, the thickness of each of the layers and the laminated number of the layers are optionally designed so as to have the characteristics required of a near-infrared cut filter. For example, by superposing a first layer of SiCₓO_{y} having thickness of 171.1nm, a second layer of TiOₜ having thickness of 100nm, a third layer of SiCₓO_{y} having thickness of 171.1nm, a forth layer of TiOₜ having thickness of 100nm, a fifth layer of SiCₓO_{y} ha ving thickness of 171.1nm, a sixth layer of TiOₜ having thickness of 100nm and a seventh layer of SiCₓO_{y} having thickness of 171.1nm, in which x is in the range of 0.1 to 3, y is in the range of 0.1 to 3 and z is in the range of 0.1 to 3, a near-infrared cut filter having the characteristics of reflecting the light of a wavelength of 850 to 1,150nm in the reflectivity of not less than 50% is generally prepared.

Subsequently, the embodiments of the antireflection film as the optical element according to the invention are explained. Fig. 3 is a section view showing an example of a structure of the antireflection film of the invention. The antireflection film of the invention has a basic structure that low refractive index layers 2 and low refractive index layers 3 are alternately superposed one by one on a substrate 1. In the invention, the low refractive index layers are formed using conductive silicon carbide as a target by a sputtering method. The use of the conductive silicon carbide as a target enables the application of high power without occurrence of crack in the target. Further, the high refractive index layers are formed using conductive titanium oxide as a target by a sputtering method. The use of the conductive titanium oxide as a target enables increase of rate for forming film.

In the laminate having the low and high refractive index layers, the thickness of each of the layers and the laminated number of the layers are optionally designed so as to have the characteristics required of an antireflection film. For example, by superposing a first layer of SiCₓO_{y} having thickness of 15nm, a second layer of TiOₜ having thickness of 30nm, a third layer of SiCₓO_{y} having thickness of 125nm and a forth layer of TiOₜ having thickness of 94.5nm, in which x is in the range of 0.1 to 3, y is in the range of 0.1 to 3 and z is in the range of 0.1 to 3, an antireflection film for visible radiation is generally prepared. The antireflection film of the invention preferably prevents reflection of light of a wavelength region of 380 to 780nm. The film preferably has reflectivity of not more than 10% with respect to the light of this wavelength region.

The substrate 1 of the invention subjecting to a sputtering method generally is a transparent substrate. Examples of materials of the substrate include glass, and plastics such as polyester (e.g., polyethylene terephthalate (PET), polybutylene terephthalate), acrylic resin (e.g., polymethyl methacrylate), polycarbonate (PC), polystyrene, polyvinylidene chloride, polyethylene, ethylene/vinyl acetate copolymer, polyvinyl butyral, metal ion crosslinked ethylene/methacrylate copolymer, polyurethane and cellophane. Especially, glass and PET are preferred.

The thickness of the substrate is not restricted as long as its transparent is maintained. In the PET substrate, the thickness is generally in the range of 150 to 200µm.

In case of using the PET substrate, a hard coat layer can be formed on the surface of the substrate to protect the surface. The thickness of the hard coat layer is generally in the range of 4 to 6µm. Examples of materials of the hard coat layer include acrylic resin, epoxy resin, urethane resin and silicone resin.

The low refractive index layer 2 is a film formed by a sputtering method using conductive silicon carbide as a target. The low refractive index layer is generally composed essentially of a compound containing Si and at least one atom selected from the group consisting of C, O, and N. The low refractive index layer is preferably composed essentially of a silicon compound selected from the group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, preferably 0.5 to 2.5, y is in the range of 0.1 to 3, preferably 0.5 to 2.5, and z is in the range of 0.1 to 3, preferably 0.5 to 2.5.

The high refractive index layer 3 is a film formed by a sputtering method using conductive titanium oxide as a target. The high refractive index layer is generally composed essentially of a compound containing Ti and O, and preferably composed essentially of TiOₜ in which t is in the range of 0.1 to 3, preferably 0.5 to 2.5.

The above conductive titanium oxide target generally means a target having volume resistivity of not more than 2E⁻¹Ω·cm. The above conductive silicon carbide target generally means a target having volume resistivity of not more than 2E⁻²Ω·cm. The use of the conductive titanium oxide and conductive silicon carbide as targets leads to increase of the rate (speed) for forming film and enables industrial production of the optical element of the invention.

The conductive silicon carbide target can be generally obtained by sintering the powder of silicon carbide together with nonmetallic sintering auxiliary agent. The conductive silicon carbide target preferably has density of not less than 2.9g/cm³. Examples of the nonmetallic sintering auxiliary agent include coal tar pitch, phenol resin, furan resin, epoxy resin, glucose, sucrose, cellulose and starch. By using the homogeneous target having high density as mentioned above, the sputtering can be carried out under stable discharge by application of high power whereby the rate for forming film can be enhanced.

By the use of conductive silicon carbide, the carbon compounds generated from the silicon carbide are vaporized in a vacuum chamber, and the resultant gases are removed from the chamber, whereby the carbon compounds are not deposited in the chamber and therefore are not entered into the optical element during the sputtering for forming film.

As the sputtering method, it is preferred to use a magnetron sputtering method. Further, a dual cathode type magnetron sputtering method is also preferred. The use of these magnetron sputtering methods enables film-formation at higher rate.

The sputtering conditions such as kind of gas, amount of flow of gas, pressure and supply electric power can be optionally set in consideration of a kind of target, rate for forming film, etc.

### EXAMPLE

The invention is illustrated in detail using the following Examples.

### [Example 1] (band-pass filter)

A low refractive index layer was formed using a magnetron sputtering equipment as a sputtering equipment. Sputtering was carried out on a glass plate as substrate using conductive silicon carbide (available from Bridgestone Corporation, resistivity: 2E⁻²Ω·cm) as target material with flowing Ar gas of 10cc/min. and oxygen gas of 3cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using conductive titanium oxide (available from Asahi Glass, resistivity: 2E⁻¹Ω·cm) as target material with flowing Ar gas of 10cc/min. under the conditions of pressure of 5mTorr and supply electric power of 1.2kW.

### [Comparison Example 1]

A low refractive index layer was formed using a magnetron sputtering equipment as a sputtering equipment. Sputtering was carried out on a glass plate as substrate using Si as target material with flowing Ar gas of 5cc/min. and oxygen gas of 5cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using Ti as target material with flowing Ar gas of 5cc/min. and oxygen gas of 5cc/min. under the conditions of pressure of 5mTorr and supply electric power of 1.2kW.

Under the above conditions, the band-pass filters having the film construction and layer thicknesses set forth in Table 1 were prepared. The optical characteristics of the resultant filters are shown in Fig. 4.

**Table 1**

| Layer | Material of Layer | Thickness (nm) | Example 1 | Com. Ex. 1 |
|---|---|---|---|---|
| | | | Time for forming layer (min.) | Time for forming layer (min.) |
| 1st Layer | TiOₜ | 58.1 | 2.42 | 29.05 |
| 2nd Layer | SiCₓO_{y} | 101.1 | 2.81 | 33.70 |
| 3rd Layer | TiOₜ | 58.1 | 2.42 | 29.05 |
| 4th Layer | SiCₓO_{y} | 101.1 | 2.81 | 33.70 |
| 5th Layer | TiOₜ | 58.1 | 2.42 | 29.05 |
| 6th Layer | SiCₓO_{y} | 101.1 | 2.81 | 33.70 |
| 7th Layer | TiOₜ | 58.1 | 2.42 | 29.05 |
| 8th Layer | SiCₓO_{y} | 176.9 | 4.91 | 58.97 |
| 9th Layer | TiOₜ | 60.0 | 2.50 | 30.00 |
| 10th Layer | SiCₓO_{y} | 176.9 | 4.91 | 58.97 |
| 11th Layer | TiOₜ | 58.1 | 2.42 | 29.05 |
| 12th Layer | SiCₓO_{y} | 101.1 | 2.81 | 33.70 |
| 13th Layer | TiOₜ | 58.1 | 2.42 | 29.05 |
| 14th Layer | SiCₓO_{y} | 101.1 | 2.81 | 33.70 |
| 15th Layer | TiOₜ | 58.1 | 2.42 | 29.05 |
| 16th Layer | SiCₓO_{y} | 101.1 | 2.81 | 33.70 |
| 17th Layer | TiOₜ | 58.1 | 2.42 | 29.05 |
| Total Time for Forming Layers | | | 48.54 | 582.53 |
| In Table 1, x is 0.8, y is 1.2 and t is 1.9. | | | | |

As shown in Table 1, the band-pass filter of Example 1 having 17 layers was prepared for approx. 50 minutes, while the band-pass filter of Comparison Example 1 was prepared for approx. 10 hours.

### [Example 2] (near-infrared cut filter)

A low refractive index layer was formed using a magnetron sputtering equipment as a sputtering equipment. Sputtering was carried out on a glass plate as substrate using conductive silicon carbide (available from Bridgestone Corporation, resistivity: 2E⁻²Ω·cm) as target material with flowing Ar gas of 10cc/min. and oxygen gas of 3cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using conductive titanium oxide (available from Asahi Glass, resistivity: 2E⁻¹Ω·cm) as target material with flowing Ar gas of 10cc/min. under the conditions of pressure of 5mTorr and supply electric power of 1.2kW.

### [Comparison Example 2]

A low refractive index layer was formed using a magnetron sputtering equipment as a sputtering equipment. Sputtering was carried out on a glass plate as substrate using Si as target material with flowing Ar gas of 5cc/min. and oxygen gas of 5cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using Ti as target material with flowing Ar gas of 5cc/min. and oxygen gas of 5cc/min. under the conditions of pressure of 5mTorr and supply electric power of 1.2kW.

Under the above conditions, the near-infrared cut filters having the film construction and layer thicknesses set forth in Table 2 were prepared. The optical characteristics of the resultant filters are shown in Fig. 5.

**Table 2**

| Layer | Material of Layer | Thickness (nm) | Example 1 | Com. Ex. 1 |
|---|---|---|---|---|
| | | | Time for forming layer (min.) | Time for forming layer (min.) |
| 1st Layer | TiOₜ | 100.0 | 4.17 | 50.00 |
| 2nd Layer | SiCₓO_{y} | 171.0 | 4.75 | 57.00 |
| 3rd Layer | TiOₜ | 100.0 | 4.17 | 50.00 |
| 4th Layer | SiCₓO_{y} | 171.0 | 4.75 | 57.00 |
| 5th Layer | TiOₜ | 100.0 | 4.17 | 50.00 |
| 6th Layer | SiCₓO_{y} | 171.0 | 4.75 | 57.00 |
| 7th Layer | TiOₜ | 100.0 | 4.17 | 50.00 |
| 8th Layer | SiCₓO_{y} | 171.0 | 4.75 | 57.00 |
| 9th Layer | TiOₜ | 100.0 | 4.17 | 50.00 |
| 10th Layer | SiCₓO_{y} | 171.0 | 4.75 | 57.00 |
| 11th Layer | TiOₜ | 15.0 | 0.63 | 7.50 |
| 12th Layer | SiCₓO_{y} | 20.0 | 0.56 | 6.67 |
| 13th Layer | TiOₜ | 100.0 | 4.17 | 50.00 |
| 14th Layer | SiCₓO_{y} | 85.6 | 2.38 | 28.53 |
| Total Time for Forming Layers | | | 52.31 | 627.70 |
| In Table 2, x is 0.8, y is 1.2 and t is 1.9. | | | | |

As shown in Table 2, the near-infrared cut filter of Example 2 having 14 layers was prepared for approx. 53 minutes, while the near-infrared cut filter of Comparison Example 2 was prepared for approx. 10.5 hours. Hence, it was proved that the near-infrared cut filter of the invention could be prepared at high speed.

### [Example 3 and Comparison Example 3]

Under the same conditions as described in Example 2 and Comparison Example 2, the near-infrared cut filters having the film construction and layer thicknesses set forth in Table 3 were prepared. The optical characteristics of the resultant filters are shown in Fig. 6.

**Table 3**

| Layer | Material of Layer | Thickness (nm) | Example 1 | Com. Ex. 1 |
|---|---|---|---|---|
| | | | Time for forming layer (min.) | Time for forming layer (min.) |
| 1st Layer | SiCₓO_{y} | 171.0 | 4.75 | 57.00 |
| 2nd Layer | TiOₜ | 100.0 | 4.17 | 50.00 |
| 3rd Layer | SiCₓO_{y} | 171.0 | 4.75 | 57.00 |
| 4th Layer | TiOₜ | 100.0 | 4.17 | 50.00 |
| 5th Layer | SiCₓO_{y} | 171.0 | 4.75 | 57.00 |
| 6th Layer | TiOₜ | 100.0 | 4.17 | 50.00 |
| 7th Layer | SiCₓO_{y} | 171.0 | 4.75 | 57.00 |
| Total Time for Forming Layers | | | 29.13 | 349.53 |
| In Table 2, x is 0.8, y is 1.2 and t is 1.9. | | | | |

As shown in Table 3, the near-infrared cut filter of Example 3 having 7 layers was prepared for approx. 30 minutes, while the near-infrared cut filter of Comparison Example 3 was prepared for approx. 5 hours 50minutes. Hence, it was proved that the near-infrared cut filter of the invention could be prepared at high speed.

### [Example 4] (antireflection film)

A low refractive index layer was formed using a magnetron sputtering equipment as a sputtering equipment. Sputtering was carried out on a glass plate as substrate using conductive silicon carbide (available from Bridgestone Corporation, resistivity: 2E⁻²Ω·cm) as target material with flowing Ar gas of 10cc/min. and oxygen gas of 3cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using conductive titanium oxide (available from Asahi Glass, resistivity: 2E⁻¹Ω·cm) as target material with flowing Ar gas of 10cc/min. under the conditions of pressure of 5mTorr and supply electric power of 1.2kW.

### [Comparison Example 4]

A low refractive index layer was formed using a magnetron sputtering equipment as a sputtering equipment. Sputtering was carried out on a glass plate as substrate material using Si as target material with flowing Ar gas of 5cc/min. and oxygen gas of 5cc/min. under the conditions of pressure of 5mTorr and supply electric power of 1.2kW.

A high refractive index layer was formed using a magnetron sputtering equipment as a sputtering equipment. Sputtering was carried out on a glass plate as a substrate using Ti as target material with flowing Ar gas of 5cc/min. and oxygen gas of 5cc/min. under the conditions of pressure of 5mTorr and supply electric power of 1.2kW.

Under the above conditions, the antireflection films having the film construction and layer thicknesses set forth in Table 4 were prepared. The optical characteristics of the resultant filters are shown in Fig. 7.

**Table 4**

| Layer | Material of Layer | Thickness (nm) | Example 1 | Com. Ex. 1 |
|---|---|---|---|---|
| | | | Time for forming layer (min.) | Time for forming layer (min.) |
| 1st Layer | SiCₓO_{y} | 15.0 | 0.63 | 7.50 |
| 2ndLayer | TiOₜ | 30.0 | 0.83 | 10.00 |
| 3rd Layer | SiCₓO_{y} | 125.0 | 5.21 | 62.50 |
| 4th Layer | TiOₜ | 945 | 2.63 | 31.50 |
| Total Time for Forming Layers | | | 9.29 | 111.50 |
| In Table 2, x is 0.8, y is 1.2 and t is 1.9. | | | | |

As shown in Table 4, the antireflection film of Example 4 having 4 layers was prepared for approx. 9.5 minutes, while the antireflection film of Comparison Example 4 was prepared for approx. 2 hours.

### [Effect of Invention]

As is apparent above, the optical element of the invention can be prepared stably and in high speed by alternately sputtering conductive silicon carbide and conductive titanium oxide as a target and hence the optical element shows high productivity.

The optical element is useful in a band-pass filter, near-infrared cut filter or antireflection film.

## Claims

1. An optical element comprising a substrate, and at least one low refractive index layer and at least one high refractive index layer superposed alternately thereon, wherein the low refractive index layer is formed using conductive silicon carbide as a target by a sputtering method and the high refractive index layer is formed using conductive titanium oxide as a target by a sputtering method.

2. An optical element as defined in claim 1, wherein the low refractive index layer comprises a compound containing Si and at least one atom selected from the group consisting of C, O and N, and the high refractive index layer comprises a compound containing Ti and O.

3. An optical element as defined in claim 1 or 2, wherein the low refractive index layer comprises a silicon compound selected from a group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, y is in the range of 0.1 to 3 and z is in the range of 0.1 to 3, and the high refractive index layer comprises TiOₜ in which t is in the range of 0.1 to 3.

4. A process for the preparation of an optical element comprising superposing alternately at least one low refractive index layer and at least one high refractive index layer which comprises the steps of:
forming the high refractive index layer using conductive titanium oxide as a target by a sputtering method, and
forming the low refractive index layer using conductive silicon carbide as a target by a sputtering method.

5. A process as defined in claim 4, wherein the sputtering method is a magnetron sputtering method.

6. A process as defined in claim 5, wherein the magnetron sputtering method is a dual cathode type magnetron sputtering method.

7. A process as defined in any of claims 4 to 6, wherein the low refractive index layer is formed in atmosphere of a mixture gas consisting of an inert gas and a reactive gas.

8. A process as defined in claim 7, wherein the reactive gas is a gas containing an oxygen atom in its molecule.

9. A process as defined in any of claims 4 to 8, wherein the low refractive index layer comprises a silicon compound selected from the group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, y is in the range of 0.1 to 3 and z is in the range of 0.1 to 3, and the high refractive index layer comprises TiOₜ in which t is in the range of 0.1 to 3.

10. An optical element comprising a substrate, and at least one low refractive index layer and at least one high refractive index layer superposed alternately thereon, wherein the low refractive index layer comprises a silicon compound selected from the group consisting of SiCₓ, SiOₓ, SiNₓ, SiCₓO_{y}, SiCₓN_{y}, SiOₓN_{y} and SiCₓO_{y}N_{z} in which x is in the range of 0.1 to 3, y is in the range of 0.1 to 3 and z is in the range of 0.1 to 3, and the high refractive index layer comprises TiOₜ in which t is in the range of 0.1 to 3.

11. An optical element as defined in claim 10, wherein the low refractive index layer comprises the SiCₓO_{y}.

12. A band-pass filter comprising an optical element as defined in any of claims 1 to 3 and 10 and 11.

13. A band-pass filter as defined in claim 12, which has light transmission of not less than 50% in a wavelength region of 560 to 620nm.

14. An near-infrared cut filter comprising an optical element as defined in any of claims 1 to 3 and 10 and 11.

15. An near-infrared cut filter as defined in claim 14, which has light transmission of not less than 50% in a wavelength region of 900 to 1,100nm.

16. An antireflection film comprising an optical element as defined in any of claims 1 to 3 and 10 and 11.

17. An antireflection film as defined in claim 16, which prevents reflection of light of a wavelength region of 380 to 780nm.
